# EUROPÄISCHE PATENTANMELDUNG

(11) **EP 1 912 331 A2**
(43) Veröffentlichungstag der Anmeldung: **16.04.2008**
(21) Anmeldenummer: 07016048.6
(22) Anmeldetag: 16.08.2007
(51) Int. Cl.: H03K 17/95

(54) **Vorrichtung zum Überwachen der Annäherung zweier relativ zueinander beweglicher Teile**

(30) Priorität: 14.10.2006 DE 202006015768 U
(71) Anmelder: SICK AG, 79183 Waldkirch (DE)
(72) Erfinder: Haberer, Christoph, 79104 Freiburg (DE)
(74) Vertreter: Ludewigt, Christoph

(57) **Zusammenfassung**

Die Erfindung betrifft eine Vorrichtung zum Überwachen der Annäherung zweier relativ zueinander beweglicher Teile mit einem Betätiger, welcher an einem der beiden beweglichen Teile angeordnet ist und einem Sensor, welcher an dem anderen der beiden beweglichen Teile angeordnet ist, wobei der Betätiger einen Transponder und der Sensor einen Empfangskreis mit einer Empfängerspule aufweisen, wobei der Transponder bei Unterschreiten eines vorgegebenen Annäherungsabstandes ein in einem Bitmuster codiertes Transpondersignal berührungslos zu dem Sensor überträgt und wobei das Transpondersignal in dem Empfangskreis mit einem gespeicherten Bitmuster verglichen wird, um an einem Ausgang ein Signal für die Überwachung zu erzeugen. Um auch das Empfangselement, welches beispielsweise als Empfängerspule ausgebildet ist, überprüfen zu können, ohne jedoch den schaltungstechnischen Aufwand zu erhöhen und somit eine verbesserte Zuverlässigkeit zu gewährleisten, wird vorgeschlagen, dass der Sensor eine Abschwächerspule aufweist, welche derart angeordnet ist, dass sie mit ihrem Magnetfeld das Magnetfeld der Empfängerspule gezielt schwächt.

## Beschreibung

Die Erfindung betrifft eine Vorrichtung zum Überwachen der Annäherung zweier relativ zueinander beweglicher Teile gemäß dem Oberbegriff des Anspruchs 1.

Hierbei ist bekannt, die Schließposition der Schutzeinrichtung zu überwachen, um insbesondere die gefährlichen Maschinen oder Anlagen zwangsweise abzuschalten, wenn die Schutzeinrichtung geöffnet wird. Zur Überwachung der Schließposition ist es z. B. aus der EP 0 968 567 B1 und der DE 103 34 653 B4 bekannt, an einem der Teile der Schutzeinrichtung, z. B. der Tür, einen Betätiger und an dem anderen Teil, z. B. dem Türrahmen, einen Sensor anzuordnen. Der Betätiger weist einen Transponder und der Sensor einen zugeordneten Empfangskreis auf. Wenn sich der Transponder in der Schließposition dem Sensor ausreichend nähert, wird der Transponder aktiviert und sendet ein in einem Muster codiertes Transpondersignal aus. Dieses wird von dem Sensor empfangen und mit einem in dem Empfangskreis des Sensors gespeicherten Bitmuster verglichen. Bei Empfang des Transpondersignals und bei Übereinstimmung der Bitmuster erfolgt eine Freigabe für die abgesicherte Einrichtung.

Um die Sicherheit der Überwachung zu verbessern, ist es aus der EP 0 968 567 B1 bekannt, die Auswertung und Verarbeitung der empfangenen Transpondersignale in dem Empfangskreis zu verdoppeln, so dass eine redundante Überwachung erfolgt. Aus der DE 103 34 653 B4 ist es bekannt, ein zusätzliches Testelement vorzusehen, welches den Empfangskreis gezielt unterbricht, um eine Öffnung der Sicherheitseinrichtung aus der Schließposition zu simulieren und das Ansprechen der Vorrichtung zu testen. Diese bekannten Maßnahmen erhöhen den schaltungstechnischen Aufwand, was insbesondere bei der Realisierung in einer Single-Chip-Ausführung mit ASIC bedeutsam ist.

Durch das Testelement, welches den Empfangskreis gezielt unterbricht, wird allerdings nur die Auswerteeinheit des Empfangskreises und nicht das Empfangselement selbst, welches insbesondere eine Empfängerspule umfasst, überprüft. Es besteht somit die Gefahr, dass ein Defekt des Empfangselements selbst nicht detektiert wird.

Der Erfindung liegt daher die Aufgabe zugrunde, eine Vorrichtung zum Überwachen der Annäherung zweier relativ zueinander beweglicher Teile zur Verfügung zu stellen, die es ermöglicht, auch das Empfangselement, welches beispielsweise als Empfängerspule ausgebildet ist, überprüfen zu können, ohne jedoch den schaltungstechnischen Aufwand zu erhöhen und somit eine verbesserte Zuverlässigkeit zu gewährleisten.

Die Aufgabe wird erfindungsgemäß gelöst durch eine Vorrichtung mit den Merkmalen des Schutzanspruchs 1.

Vorteilhafte Ausführungen und Weiterbildungen der Erfindung sind in den Unteransprüchen angegeben.

Bei der erfindungsgemäßen Vorrichtung zum Überwachen der Annährung zweier relativ zueinander beweglicher Teile weist der Sensor eine Abschwächerspule auf, welche derart angeordnet ist, dass sie mit ihrem Magnetfeld das Magnetfeld der Empfängerspule gezielt schwächt. Zu Testzwecken der Empfängerspule kann somit die Abschwächerspule, beispielsweise zu bestimmten Zeiten, eingeschaltet werden, um das Magnetfeld der Empfängerspule zu schwächen und somit die Energieversorgung des Transponders zu unterbrechen. Dadurch wird das Empfangssignal geschwächt oder vollständig unterdrückt. Wird das Signal des Transponders durch diese Testung unterbrochen, kann damit die korrekte Funktion des Sensors, insbesondere die Funktionsweise der Empfängerspule, überprüft werden. Die Überprüfung ist somit nicht lediglich eine Überprüfung der Auswerteeinheit des Sensors, sondern tatsächlich eine Prüfung des Empfangselements selbst, d. h. der Empfängerspule.

Damit eine Schwächung des Magnetfelds der Empfängerspulen durch das Magnetfeld der Abschwächerspule auftritt, sind vorzugsweise die Empfängerspule und die Abschwächerspule gegenphasig ansteuerbar.

Bei einer besonders vorteilhaften Ausgestaltung der Erfindung ist die Stärke des Magnetfeldes der Abschwächerspule regelbar, um auf diese Weise auch den Abstand des Transponders, d. h. des Betätigers, zu dem Sensor ermitteln zu können. Wird nämlich zunächst das Magnetfeld der Abschwächerspule sehr stark eingestellt, wird das Magnetfeld der Empfängerspule sehr stark geschwächt und weist somit nur eine geringe Feldstärke auf. Anschließend kann die Feldstärke des Sensors schrittweise erhöht werden, indem die Stärke des Magnetfeldes der Abschwächerspule verringert wird. Erst ab einer gewissen Feldstärke der Empfängerspule kann in der Empfängerspule das Antwortsignal des Transponders detektiert werden, woraus sich der Abstand zwischen der Empfängerspule und dem Transponder ermitteln lässt. Insbesondere kann dabei auch eine Regelung der Stärke des Magnetfeldes der Abschwächerspule in einem bestimmten Rhythmus erfolgen, so dass beispielsweise durch die Abschwächerspulen auch der Transponder simuliert werden kann, wenn der Rhythmus, in dem die Stärke des Magnetfelds der Abschwächerspule geregelt wird, beispielsweise einer charakteristischen Bitfolge des Transponders entspricht. Da in der Regel die Abschwächerspule deutlich näher an der Empfängerspule angeordnet ist als der Transponder, kann mit Hilfe der Abschwächerspule die Empfängerspule auf ihre korrekte Funktion hin überprüft werden, da das in der Empfängerspule erzeugte Signal der Abschwächerspule deutlich stärker ist, als das Signal eines eventuell weiter entfernten Transponders. Zu Testzwecken kann auch eine Bitfolge gewählt werden, die gerade nicht der Bitfolge des Transponders, sondern einem Zufallsignal entspricht, so dass die Abschaltfähigkeit des Sensors überprüft werden kann, da die Zufallsfolge das erwartete Signal des Transponders übertönt und somit nicht mehr die erwartete Bitfolge des Transponders in der Empfängerspule detektiert werden kann.

Die Stärke des Magnetfelds der Abschwächerspule kann insbesondere über einen regelbaren Widerstand oder über einen FET-Transistor geregelt werden.

Um die Abschwächerspule gezielt zu- oder abschalten zu können, ist die Abschwächerspule vorzugsweise über ein Schaltelement steuerbar. Mit Hilfe dieses Schaltelements ist die Abschwächerspule ein- oder ausschaltbar, wobei bei einer entsprechenden Ansteuerung des Schaltelements ebenfalls ein variierendes Signal entsprechend einer Bitfolge erzeugbar ist. Insbesondere ist das Schaltelement als Halbleiterelement ausgebildet.

Bei einer vorteilhaften Ausführungsform ist die Abschwächerspule in den Empfängerkreis integriert. Um dabei erreichen zu können, dass das Magnetfeld der Abschwächerspule das Magnetfeld der Empfängerspule abschwächt, müssen dabei die beiden Spulen derart geschaltet werden, dass sie in entgegengesetzter Richtung vom Strom durchflossen werden bzw. dass sie gegensinnig gewickelt sind.

In einer alternativen Ausführungsform weist die Abschwächerspule eine von dem Empfängerkreis unabhängige Spannungsversorgung auf, wodurch es einfacher ermöglicht wird, die Stärke des Magnetfelds der Abschwächerspule unabhängig von der Stärke des Magnetfelds der Empfängerspule zu regeln.

Bei einer besonders vorteilhaften Ausführungsform der Erfindung sind die Empfängerspule und die Abschwächerspule auf einem gemeinsamen Magnetkern angeordnet, um die Kopplung zwischen den beiden Spulen zu verbessern. Vorzugsweise ist dabei der Magnetkern als Ferrit ausgebildet.

Die erfindungsgemäße Vorrichtung wird vor allem im Bereich der Maschinen- und Anlagensicherheit eingesetzt, wobei die Anlagen zum Schutz der an den Anlagen arbeitenden Person von Schutzzäunen umgeben sind, in welche Schutztüren eingesetzt sind. Der Betätiger der vorliegenden Vorrichtung ist dabei vorzugsweise an der Tür angeordnet, während der Sensor der vorliegenden Vorrichtung vorzugsweise am Türrahmen angeordnet ist, so dass mit Hilfe der Vorrichtung überprüft werden kann, ob die Tür geschlossen ist oder geöffnet wurde.

Die Erfindung wird anhand der folgenden Figuren ausführlich erläutert. Es zeigt:
- Figur 1: eine schematische Darstellung einer ersten Ausführungsform der Erfindung und
- Figur 2: eine schematische Darstellung einer zweiten Ausführungsform der

Erfindung.

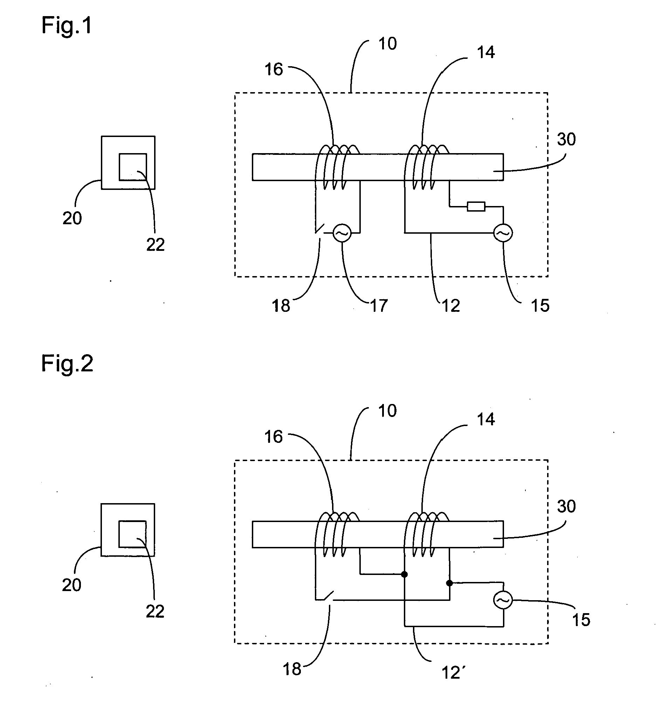

In den Figuren 1 und 2 sind zwei Ausführungsbeispiele einer Vorrichtung zum Überwachen der Annäherung zweier relativ zueinander beweglicher Teile dargestellt, wobei gleiche Bezugsziffern gleiche Teile bezeichnen. Bei den relativ zueinander beweglichen Teilen handelt es sich insbesondere um eine nicht dargestellte Tür, welche in einem feststehenden Türrahmen verschwenkbar ist.

Die Vorrichtung weist einen Sensor 10 auf, welcher beispielsweise an einem feststehenden Türrahmen angeordnet sein kann. Weiterhin weist die Vorrichtung einen Betätiger 20 auf, welcher separat von dem Sensor 10 angeordnet ist, so dass es sich bei der Vorrichtung um einen berührungslos wirkenden Näherungssensor handelt. Der Betätiger 20 ist beispielsweise an einer in dem feststehenden Türrahmen schwenkbaren Tür angeordnet, so dass er sich bei geschlossener Tür in einer Position nahe des Sensors 10 befindet und sich beim Öffnen der Tür vom Sensor 10 entfernt. In dem Betätiger 20 ist ein Transponder 22 angeordnet, welcher insbesondere als passiver Transponder ausgebildet ist.

In dem ersten Ausführungsbeispiel, welches in Figur 1 dargestellt ist, weist der Sensor 10 einen Empfangskreis 12 auf, in welchem eine Empfängerspule 14 angeordnet ist. In dem Empfangskreis 12 ist eine Spannungsversorgung 15 angeordnet mit Hilfe derer ein Strom durch die Empfängerspule 14 geschickt werden kann, um ein Magnetfeld in der Empfängerspule 14 zu erzeugen. Die Empfängerspule 14 dient dabei einerseits als Sender des Magnetfeldes, welches, sofern sich der Transponder 22 nahe genug an dem Sensor 10 befindet, die Energieversorgung des Transponders 22 darstellt und bewirkt, dass der Transponder 22 bei Unterschreiten eines vorgegebenen Annäherungsabstandes ein in einem Bitmuster codiertes Transpondersignal an den Sensor 10 überträgt. Die Empfangsspule 14 dient andererseits auch als Empfänger, da von ihr dieses Transpondersignal detektiert und in dem Empfangskreis 12, insbesondere in einer in dem Empfangskreis 12 nicht dargestellten Auswerteeinheit, mit einem gespeicherten Bitmuster verglichen wird, um anschließend ein Ausgangssignal für die Überwachung zu erzeugen.

Damit der Empfangskreis 12 und insbesondere die Empfängerspule 14 daraufhin überprüft werden kann, ob die Empfängerspule 14 korrekt funktioniert, ist in dem Sensor 10 eine Abschwächerspule 16 angeordnet. Die Abschwächerspule 16 wird ebenfalls über eine Spannungsversorgung 17 mit Strom versorgt. Die Empfängerspule 14 und die Abschwächerspule 16 sind gemeinsam auf einem Magnetkern 30, insbesondere einem Ferrit, angeordnet, wobei die Wicklungen der Empfängerspule 14 und der Abschwächerspule 16 gleichsinnig um den Magnetkern 30 verlaufen. Damit die Abschwächerspule 16 ein Magnetfeld erzeugt, welches das Magnetfeld der Empfängerspule 14 schwächt, ist es nötig, einen Strom in entgegengesetzter Richtung durch die Empfängerspule 14 und die Abschwächerspule 16 fließen zu lassen. An der Abschwächerspule 16 ist zusätzlich ein Schaltelement 18 angeordnet, mit welcher die Abschwächerspule 16 ein- und ausgeschaltet werden kann, so dass eine gezielte, insbesondere nur zeitweise Abschwächung des Magnetfeldes der Empfängerspule 14 durch das Magnetfeld der Abschwächerspule 16 vorgenommen werden kann. Nicht dargestellt ist eine weitere Steuerung für die Abschwächerspule 16, mit welcher im eingeschalteten Zustand der Abschwächerspule 16 auch die Stärke des Magnetfeldes der Abschwächerspule 16 geregelt werden kann.

Das in Figur 2 dargestellte Ausführungsbeispiel der Erfindung unterscheidet sich von dem in Figur 1 dargestellten Ausführungsbeispiel dadurch, dass die Abschwächerspule 16 und die Empfängerspule 14 eine gemeinsame Spannungsversorgung 15' aufweisen, wobei die Empfängerspule 14 und die Abschwächerspule 16 in einem gemeinsamen Empfangskreis 12' geschaltet sind. Die Abschwächerspule 16 und die Empfängerspule 14 sind dabei parallel geschaltet, wobei die Abschwächerspule 16 wiederum durch das Schaltelement 18 zugeschaltet werden kann. Die Abschwächerspule 16 und die Empfängerspule 14 sind wiederum gemeinsam auf dem Magnetkern 30 angeordnet, wobei ihre Wicklungen gleichsinnig um den Magnetkern verlaufen. Die Empfängerspule 14 und die Abschwächerspule 16 sind insbesondere derart parallel geschaltet, dass sowohl ihre auf dem Magnetkern 30 einander zugewandten Enden als auch ihre auf dem Magnetkern 30 einander abgewandten Enden jeweils mit dem gleichen Pol der Spannungsversorgung 15' verbunden sind, so dass bei gleicher Wicklung der Empfängerspule 14 und der Abschwächerspule 16 auf dem Magnetkern 30 die beiden Spulen 14, 16 in entgegengesetzter Richtung vom Strom durchflossen werden, so dass das in der Abschwächerspule 16 erzeugte Magnetfeld das Magnetfeld der Empfängerspule 14 schwächt. Die korrekte Wicklung und Verschaltung der Empfängerspule 14 und der Abschwächerspule 16 und somit die korrekte gegenphasige Ansteuerung der beiden Spulen 14, 16, kann mit Hilfe einer zusätzlichen nicht dargestellten Prüfspule überprüft werden.

Ein fälschliches Auslösen und Ausgeben eines Signals für die Überwachung durch den Sensor 10 kann dadurch überprüft werden, dass mit der Abschwächerspule 16 das Magnetfeld der Empfängerspule 14 soweit geschwächt wird, dass die Energieversorgung des Transponders 22 unterbrochen wird und damit der Empfangskreis 12, 12' kein Signal des Transponders 22 mehr detektiert. Falls trotzdem ein entsprechendes Signal zur Überwachung am Ausgang anliegen sollte, d. h. dass der Sensor 10 trotz der Feldabschwächung durch die Abschwächerspule 16 das Ausgangssignal nicht abschaltet, kann somit die Fehlfunktion des Sensors 10 ermittelt werden.

### Bezugszeichenliste

- 10: Sensor
- 12: Empfangskreis
- 12': Empfangskreis
- 14: Empfangsspule
- 15: Spannungsversorgung
- 15': Spannungsversorgung
- 16: Abschwächungsspule
- 17: Spannungsversorgung
- 18: Schaltelement

- 20: Betätiger
- 22: Transponder

- 30: Magnetkern

## Patentansprüche

1. Vorrichtung zum Überwachen der Annäherung zweier relativ zueinander beweglicher Teile mit einem Betätiger (20), welcher an einem der beiden beweglichen Teile angeordnet ist und einem Sensor (10), welcher an dem anderen der beiden beweglichen Teile angeordnet ist, wobei der Betätiger (20) einen Transponder (22) und der Sensor (10) einen Empfangskreis (12, 12') mit einer Empfängerspule (14) aufweisen, wobei der Transponder (22) bei Unterschreiten eines vorgegebenen Annäherungsabstandes ein in einem Bitmuster codiertes Transpondersignal berührungslos zu dem Sensor (10) überträgt und wobei das Transpondersignal in dem Empfangskreis (12, 12') mit einem gespeicherten Bitmuster verglichen wird, um an einem Ausgang ein Signal für die Überwachung zu erzeugen, **dadurch gekennzeichnet, dass** der Sensor (10) eine Abschwächerspule (16) aufweist, welche derart angeordnet ist, dass sie mit ihrem Magnetfeld das Magnetfeld der Empfängerspule (14) gezielt schwächt.

2. Vorrichtung nach Anspruch 1, **dadurch gekennzeichnet, dass** die Empfängerspule (14) und die Abschwächerspule (16) gegenphasig ansteuerbar sind.

3. Vorrichtung nach Anspruch 1 oder 2, **dadurch gekennzeichnet, dass** die Stärke des Magnetfelds der Abschwächerspule (16) regelbar ist.

4. Vorrichtung nach Anspruch 3, **dadurch gekennzeichnet, dass** die Stärke des Magnetfelds der Abschwächerspule (16) über einen regelbaren Widerstand oder über einen FET-Transistor regelbar ist.

5. Vorrichtung nach einem der vorhergehenden Ansprüche, **dadurch gekennzeichnet, dass** die Abschwächerspule (16) über ein Schaltelement (18) steuerbar ist.

6. Vorrichtung nach Anspruch 5, **dadurch gekennzeichnet, dass** das Schaltelement (18) als Halbleiterelement ausgebildet ist.

7. Vorrichtung nach einem der vorhergehenden Ansprüche, **dadurch gekennzeichnet, dass** die Abschwächerspule (16) in den Empfängerkreis (12') integriert ist.

8. Vorrichtung nach einem der Ansprüche 1 bis 6, **dadurch gekennzeichnet, dass** die Abschwächerspule (16) eine von dem Empfängerkreis (12) unabhängige Spannungsversorgung (17) aufweist.

9. Vorrichtung nach einem der vorhergehenden Ansprüche, **dadurch gekennzeichnet, dass** die Empfängerspule (14) und die Abschwächerspule (16) auf einem gemeinsamen Magnetkern (30) angeordnet sind.

10. Vorrichtung nach einem der vorhergehenden Ansprüche, **dadurch gekennzeichnet, dass** die beiden beweglichen Teile als Tür und Türrahmen ausgebildet sind.
